# EUROPEAN PATENT SPECIFICATION

(11) **EP 1 137 177 B1**
(45) Date of publication and mention of the grant of the patent: **21.01.2009**
(21) Application number: 01300766.1
(22) Date of filing: 29.01.2001
(51) Int. Cl.: H03H 9/64, H03H 9/72

(54) **Surface acoustic wave device, communication device using the same, and antenna duplexer**
Akustische Oberflächenwellenvorrichtung, diese enthaltende Kommunikationsvorrichtung und Antennenweiche
Dispositif à ondes acoustiques de surface, dispositif de communication le contenant et duplexeur d'antenne

(30) Priority: 17.03.2000 JP 2000075177
(43) Date of publication of application: 26.09.2001
(73) Proprietor: Fujitsu Media Devices Limited, Suzaka-shi, Nagano 382-8501 (JP)
(72) Inventor: Nishizawa, Toshio, c/o Fujitsu Media, Suzaka-shi, Nagano, 382-8501 (JP); Ueda, Masanori, c/o Fujitsu Media, Suzaka-shi, Nagano, 382-8501 (JP); Kawachi, Osamu, c/o Fujitsu Media, Suzaka-shi, Nagano, 382-8501 (JP); Misawa, Kiyohide, c/o Fujitsu Media, Suzaka-shi, Nagano, 382-8501 (JP); Furusato, Hiroyuki, c/o Fujitsu Media, Suzaka-shi, Nagano, 382-8501 (JP)
(74) Representative: Stebbing, Timothy Charles

(56) References cited:
- EP-A- 0 602 666
- EP-A- 0 722 218
- DE-A- 19 806 550
- US-A- 5 991 989

## Description

The present invention relates generally to a surface acoustic wave device and a communication device using the same. More particularly, the present invention relates to a surface acoustic wave device which uses flip chip bonding technology, can be downsized, and further has high reliability, and a communication device and an antenna duplexer using the same.

In recent years, starting with portable telephones the downsizing of communication devices is conspicuous. Together with a demand for the downsizing of such devices, a demand for the downsizing and reduction in the heights of parts for use therein is increased.

In particular, in the communication device, a filter, a resonator, and a delay line device are essential parts, and the downsizing thereof is realized by a SAW (Surface Acoustic Wave) device using a flip chip bonding technology.

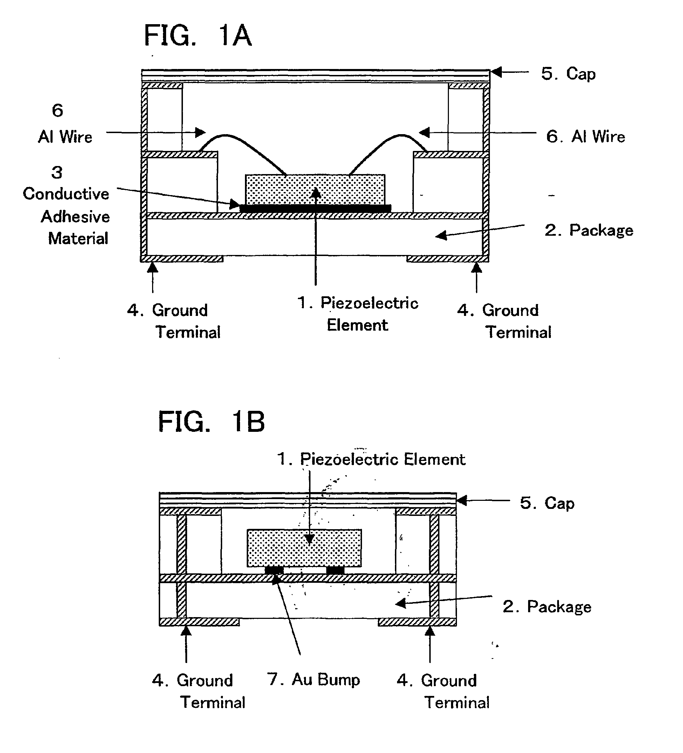

Figs. 1A and 1B are schematic cross-sectional views showing a method for mounting,on a package, such a surface acoustic wave device.

Fig. 1A shows a method for mounting a SAW device on a package using a wire bonding technology. The surface acoustic wave element is formed on a piezoelectric element (chip) 1.

This piezoelectric element 1 is mounted on a package 2 having a recess part formed with a dielectric material such as a ceramic, etc., and is pasted and fixed with a conductive adhesive material 3. After the piezoelectric element 1 is mounted on the package 2, it is sealed by a cap 5. Furthermore, a conductive metal plate connected to a ground terminal 4 of the reverse face is provided on an outer surface of the package 2 or metal plating. -

Here, an appropriate electrode on the piezoelectric element 1 is connected to an electrode corresponding to the package 2 via an Al wire 6. Accordingly, a predetermined package height must be allowed due to the A1 wire 6.

In this manner, in the case of the wire bonding technology shown in Fig. 1A, the scope for reduction in height is limited. Fig. 1B shows an example using a flip chip bonding technology as a technology for solving this.

In comparison with Fig. 1A, in the flip chip bonding technology of Fig. 1B, an appropriate electrode on the piezoelectric element 1 is connected to an electrode corresponding to the package 2 via an Au bump 7. Accordingly, compared with a height direction in the case of the Al wire 6, a reduction in height is possible.

Here, in the flip chip bonding technology of Fig. 1B, a connection face between the piezoelectric element 1 and the package 2 is determined by the size of the Au bump 7, and becomes smaller than the case of the wire bonding technology. On the other hand, a difference in coefficients of linear expansion between the piezoelectric element 1 and the package 2 for general use exists.

For this reason, at the time of a temperature cycle given at a test stage, a stress load applied on the bump 7 is increased. This is a factor (disconnection, etc.) which reduces reliability in the device, and further a factor which prevents the flip chip bonding technology from being adopted for downsizing.

EP-A-0 722 218 discloses a surface acoustic wave device according to the preamble of claim 1. The piezoelectric element, which is mounted to the package by flip chip bonding, is covered by a metal cap. The thermal expansion coefficients α1, α2 and α3 of the piezoelectric element, substrate and cap along the surface wave propagation direction are set so that α3 > α1 when α1 > α2 and α3 ≤ α1 when α1 < α2.

EP-A-0 602 666 discloses that the thermal expansion coefficient of lithium niobate differs according to the direction relative to the crystal orientation.

It is a consideration of the present invention to provide a surface acoustic wave device which enables a downsizing and high reliability, and a communication device and an antenna duplexer using the same.

According to a first aspect of the present invention there is provided a surface acoustic wave device, comprising:
a package having a coefficient of linear expansion; and
a piezoelectric element forming a surface acoustic wave element, and mounted on the package by flip chip bonding characterised in that: the piezoelectric element has different coefficients of linear expansion in first and second directions, the first direction being a direction of propagation of surface acoustic waves generated by interdigital electrodes of the surface acoustic wave element and the second direction being perpendicular thereto, and further having a long side extending in whichever of the first and second directions has a coefficient of linear expansion closer to that of the package.

Preferably, the piezoelectric element further has electrode patterns, and positions of bumps which connect the electrode patterns with the package are disposed point-symmetrically to a center of the piezoelectric element.

Preferably, the electrode patterns are formed so that a distance from a center of the piezoelectric element is 1/2 or less of a short side of the piezoelectric element.

Preferably, the surface acoustic wave element has electrode patterns configuring a ladder-type filter. Preferably, all positions of the bumps which connect the electrode patterns with the package are disposed at a side closer to a center of the piezoelectric element than a resonator disposed at a side of the short side of the ladder-type filter.

According to a second aspect of the present invention there is provided a surface acoustic wave device, comprising:
a package having a coefficient of linear expansion; and a surface acoustic wave element mounted on the package by flip chip bonding; characterised in that: the surface acoustic wave element is formed by two piezoelectric elements, each of the two piezoelectric elements having different coefficients of linear expansion in first and second directions, the first direction being a direction of propagation of surface acoustic waves generated by interdigital electrodes of the surface acoustic wave element and the second direction being perpendicular thereto, and having a long side extending in whichever of the first and second directions has a coefficient of linear expansion closer to that of the package, and in that each of the piezoelectric elements has respective different central frequencies.

Preferably, ground electrodes of the surface acoustic wave element formed respectively on the two piezoelectric elements are common in the package.

Preferably, the ground electrodes of the surface acoustic wave elements formed respectively on the two piezoelectric elements are independent in the package.

Preferably, the surface acoustic wave element is a double mode type filter, in which an input side ground electrode and output side ground electrode of the filter are separated in the package.

Preferably, the surface acoustic wave element formed in any one of the two piezoelectric elements is a cascade-connected double mode type filter, in which an input side ground electrode and output side ground electrode of the filter are separated in the package.

Preferably, the piezoelectric element is cut out from a single crystal having X, Y, and Z crystal axes, and the X crystal axis is arranged in a direction of propagation of the surface acoustic waves.

Preferably, the piezoelectric element is cut out from a LiTaO₃ single crystal rotated around the X axis at a rotated angle from the Y axis to the Z axis, the rotated angle being in a range between 40° and 44°.

Other aspects of the present invention are as defined in the accompanying independent claims.

A detailed description of embodiments of the present invention will now be given, by way of example, with reference to the accompanying drawings, in which:
Figs. 1A and 1B are schematic cross-sectional views showing a method for mounting a SAW device on a package;
Fig. 2 is a plan view of a piezoelectric element 1 formed with a conventional surface acoustic wave element;
Fig. 3 is an equivalent circuit of a ladder type filter formed by the surface acoustic wave element of Fig. 2;
Fig. 4 is a diagram showing a configuration according to an embodiment of the present invention;
Fig. 5 is a view for explaining mounting of the piezoelectric element on a ceramic package;
Fig. 6 is an example of a surface acoustic wave element having an interdigital electrode configuration according to the present invention, and is a diagram showing an example of an IIDT (Interdigitated Interdigital Transducer) type filter;
Fig. 7 is an example of a cascade-connected double mode type filter according to an embodiment of the invention;
Fig. 8 is a top view of the piezoelectric element 1 forming another surface acoustic wave filter of a double mode type;
Fig. 9 is a view for explaining a characteristic of the present invention;
Fig. 10 is a view showing an embodiment for explaining another characteristic of the present invention;
Fig. 11 is a block diagram centering a radio communication device, for example, a high frequency circuit of a portable telephone;
Fig. 12 is a block diagram centering another high frequency circuit of the portable telephone;
Fig. 13 is a view for explaining the mounting of the surface acoustic wave device according to an embodiment of the present invention conducive to downsizing the surface acoustic wave device;
Fig. 14 is a view showing the condition of connection bumps 7 after mounting according to the embodiment of Fig. 13;
Fig. 15 is another example, in which two piezoelectric elements 1 are mounted via electrode pads onto separate ground terminals 4 in a common package 2; and
Fig. 16 is another example, in which input and output ground electrode pads of a double mode type filter formed on one of the piezoelectric elements 1 are separated from each other so that one of the electrode pads connects with one ground terminal 4 of the package.

In the drawings, the same reference numerals or reference symbols are assigned to the same or similar components or elements for explanation.

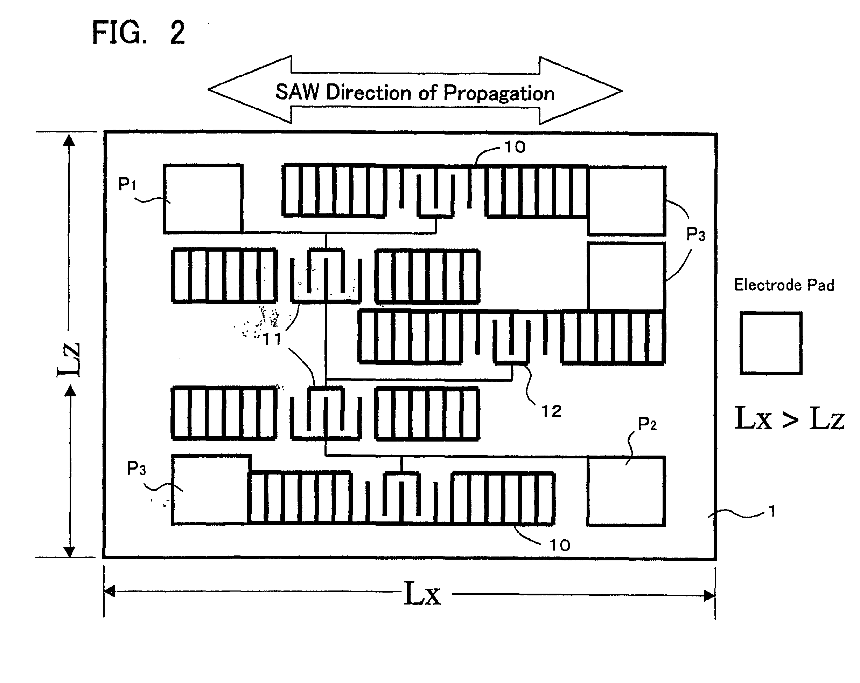

Fig. 2 is a plan view of a piezoelectric element 1 formed with a conventional surface acoustic wave element.

Here, the piezoelectric element 1 is obtained by dividing a piezoelectric substrate (wafer) cut out at a predetermined angle from a single crystal (e.g. a LiTaO₃ crystal), having X, Y, and Z crystal axes, into a plurality of rectangular parallelepiped chips. The piezoelectric element 1 has sides corresponding to the crystal axes. In the example of Fig. 2, a long side Lx is a side along the X axis, and a short side Lz is a side along the Z axis.

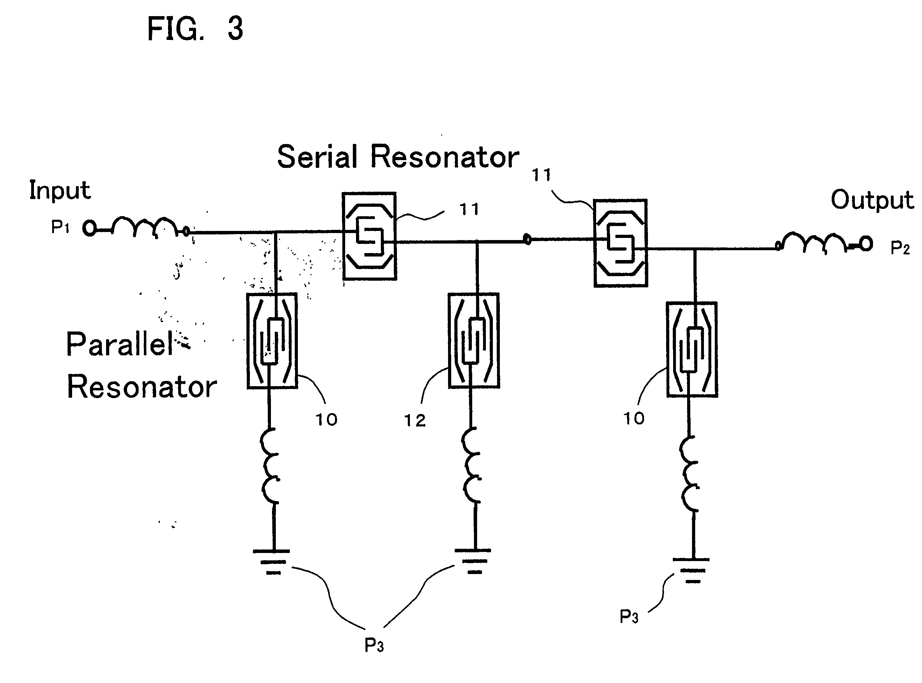

A surface acoustic wave element formed on the piezoelectric element 1 has interdigital electrodes 10, 12, 11, and is connected to an input electrode pad P₁, an output electrode pad P₂, and a ground electrode pad P₃ so that the interdigital electrodes 10, 12 are configured as parallel-resonators, and the interdigital electrode 11 is configured as a serial-resonator, and constitutes a ladder-type filter. Fig. 3 is an equivalent circuit of the ladder-type filter composed of the surface acoustic wave element of Fig. 2, which has two steps of the serial-resonation circuit 11, and three steps of the parallel-resonance circuits 10, 12.

Here, in Fig. 2, the long side Lx of the piezoelectric element 1 is arranged in a direction of propagation of the surface acoustic wave (SAW) by the interdigital electrodes of the surface acoustic wave element. Furthermore, this piezoelectric element 1 differs between a coefficient of linear expansion in a direction of the long side Lx and a coefficient of linear expansion in a direction of the short side Lz.

The crystal axis as the direction of propagation of these surface acoustic waves (SAW) and the coefficient of linear expansion in directions of the respective sides is single-significant according to a type and cutout angle of the single crystal of the cut-out piezoelectric substrate.

For example, in the piezoelectric substrate cut out from the LiTaO₃ single crystal, the coefficient of linear expansion in the direction of propagation (in a direction along the X axis) of the surface acoustic wave is αx=16.1ppm, and the coefficient of linear expansion in the perpendicular direction (in a direction along the Z axis) thereof is αz=9.5ppm.

On the other hand, in the case where the piezoelectric element 1 shown in Fig. 2 is mounted on a package 2 by flip chip bonding technology, the piezoelectric element 1 is connected to electrodes on the package 2 by a bump 7 at positions corresponding to respective electrode pads P₁, P₂, P₃, as shown in Fig. 1.

However, the package 2 itself has the coefficient of linear expansion. For example, in the case of using a ceramic package, the coefficient of linear expansion is about α=7 to 8ppm.

Accordingly, in the piezoelectric element 1 shown in Fig. 2, a difference between the coefficient of linear expansion of a side in the direction of propagation of the surface acoustic wave, namely the long side Lx,and the coefficient of linear expansion of the package 2 is increased, which in this case, causes stress on the bump 7, resulting in an unreliable connection.

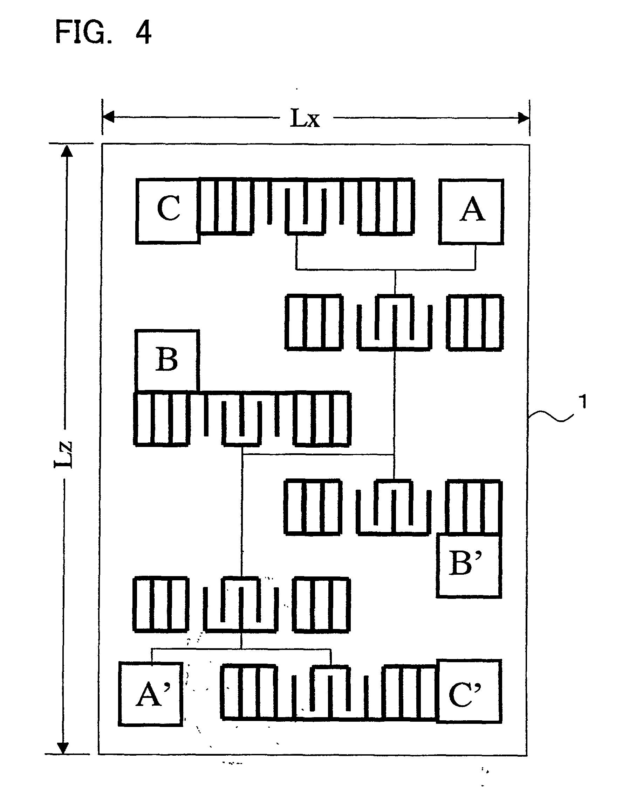

Fig. 4 shows a configuration of one embodiment of the present invention, and is a plan view of the same piezoelectric element 1 as in Fig. 2. According to the embodiment of Fig. 4, in comparison with the example of Fig. 2, the long side of the piezoelectric element 1 is counter to the short side thereof. Namely, Lz is now the long side along a Z axis, and Lx is the short side along an X axis.

In this manner, according to the present invention, the side Lz which is closer to the coefficient of linear expansion of the package 2 is configured as the long side. Thus, in comparison with the prior art shown in Fig. 2, the stress on the bump 7 can be decreased.

In the piezoelectric substrate cut out from the above LiTaO₃ single crystal rotated around the X axis at rotated angles of 40 degrees, 42 degrees, and 44 degrees from the Y axis to the Z axis, the coefficient of linear expansion in a direction along the X axis is αx=16.1ppm, and the respective coefficients of linear expansion in a direction along the Z axis are αz=9.1ppm, 9.5ppm, and 9.9ppm. Therefore, even in the case where the piezoelectric substrate is cut out at any of the rotational angles, in comparison with a direction along the X axis, the coefficient of linear expansion of a ceramic package is close to α=7 to 8ppm.

Furthermore, as another example, in the case of using a LiNbO₃ crystal, where the rotational angle from the Y axis to the Z axis is 41 degrees around the X axis, the coefficient of linear expansion in an X axial direction is αx=15.4ppm, and the coefficient of linear expansion in a Z direction is αz=10.9ppm. In the case of using a LiNbO₃ crystal, where the rotational angle from the Y axis to the Z axis is 64 degrees around the X axis, the coefficient of linear expansion in the X axial direction is αx=15.4ppm, and the coefficient of linear expansion in the Z direction is αz=13.9ppm. In this case also, the coefficient of linear expansion in the direction along the Z axis is closer to the coefficient of linear expansion of the ceramic package α=7 to 8ppm than to the coefficient of linear expansion in the X axial direction.

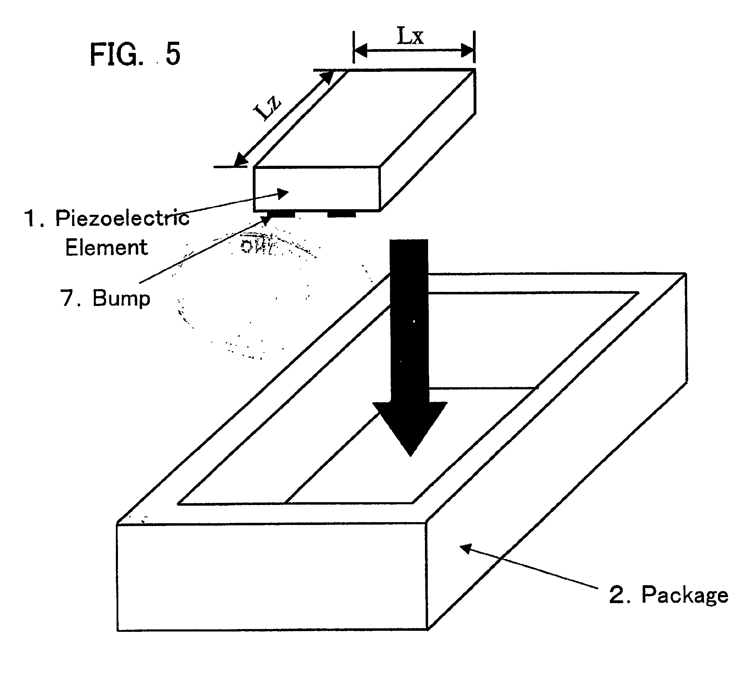

In any case, since the direction along the Z axis having the coefficient of linear expansion closer to the coefficient of linear expansion of the ceramic package is set as the long side, it is possible to decrease the stress on the bump. In this manner, according to the present invention, by using the piezoelectric element 1 in which the direction along the crystal axis having the coefficient of linear expansion closer to the coefficient of linear expansion of the package 2 is set as the long side, this piezoelectric element 1 is mounted on the ceramic package 2 as shown in Fig. 5, connecting with the electrodes of the package 2 via the bumps 7. Thus, a surface acoustic wave device of high reliability can be obtained.

Returning to Fig. 4, another characteristic of the present invention will be explained. That is, in Fig. 4, electrode pads A, A', and B, B', and C, C' are disposed point-symmetrically to a center of the piezoelectric element 1, respectively.

When the electrode pads are disposed point-symmetrically to a center of the piezoelectric element 1, the stress loads applied on the bumps in response to the positions of the electrode pads can be dispersed respectively.

The above adaptation of the present invention is not limited to the surface acoustic wave element having the ladder-type interdigital electrode structure shown in Fig. 4, as the surface acoustic wave element formed on the piezoelectric element 1, but may be applied to cases where the surface acoustic wave element has other interdigital electrode structures.

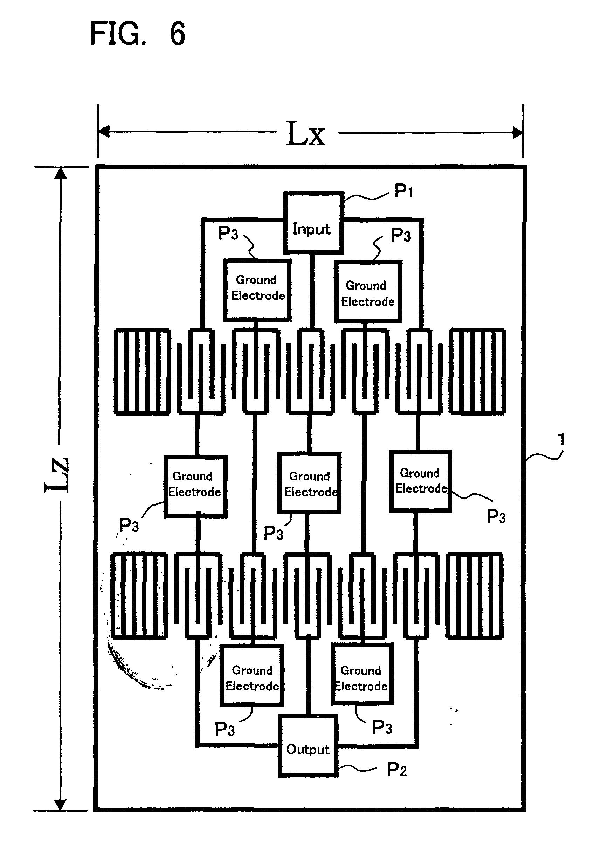

For example, Figs. 6 to 8 are examples of surface acoustic wave elements having other interdigital electrode structures. In particular, the example shown in Fig. 6 is one of an IIDT (Interdigitated Interdigital Transducer) type filter, and a side along the Z axis is set as the long side Lz. In the example of Fig. 6, the ground electrode pads P₃ are disposed symmetrically in relation to the I/O electrode pads P₁ and P₂.

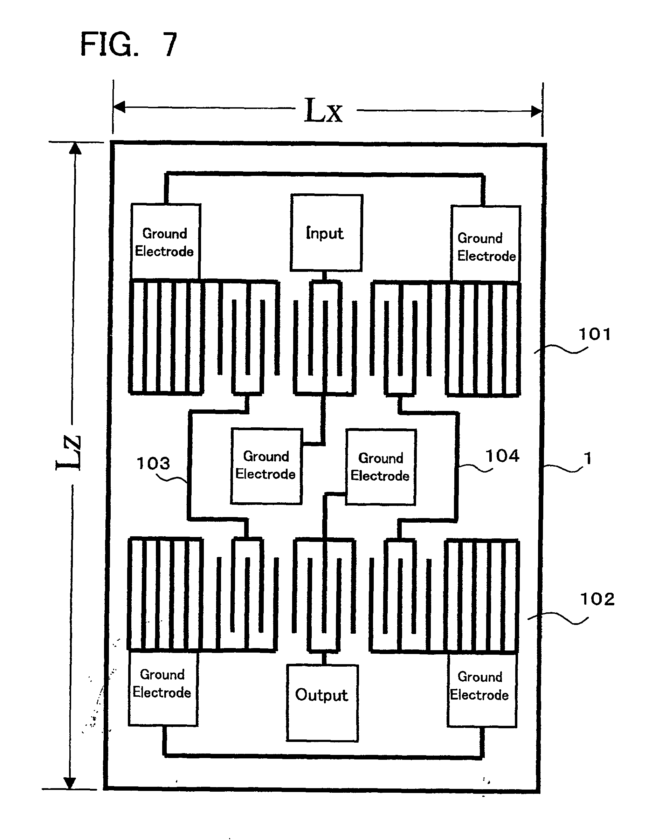

Fig. 7 is an example of a cascade-connected double mode type filter, and the long side is set in a direction along the Z axis. In Fig. 7, a first double mode type filter 101 is cascade-connected to a second double mode type filter 102 via connection electrodes 103, 104. Thus, a filter having higher selectivity is constituted by the two double mode type filter stages.

Furthermore, in Fig. 7 also, the electrode pads are disposed point-symmetrically to a center point of the piezoelectric element 1.

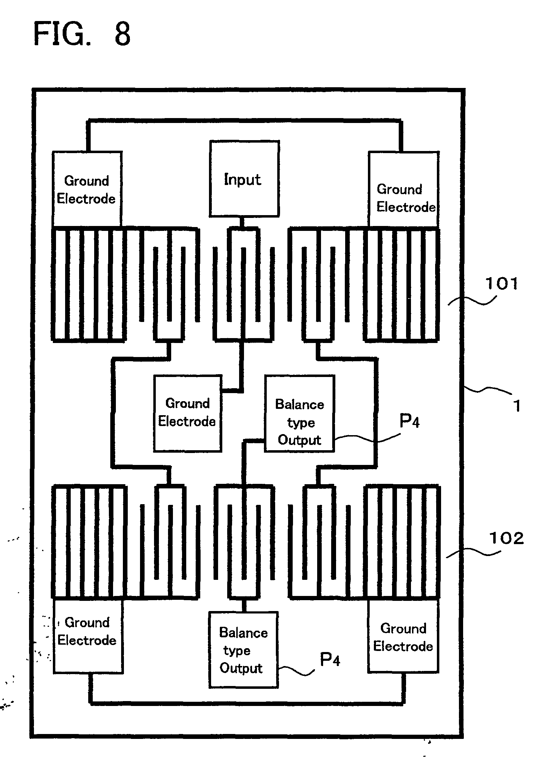

Fig. 8 is further a top view of the piezoelectrie element 1 forming another surface acoustic wave filter of a double mode type. In particular, this is an example which has the two double mode type filters 101, 102 cascaded-connected, and is of a balance type in which the output is taken from two output electrode pads P₄.

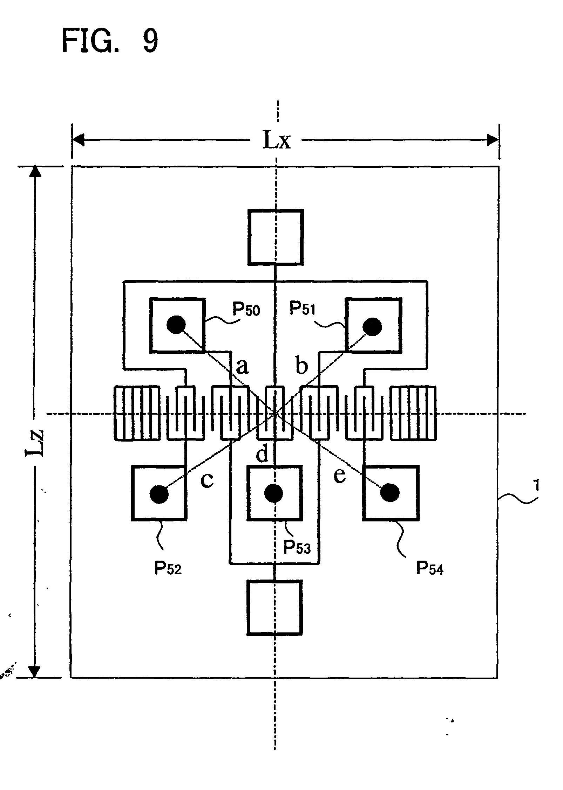

Fig. 9 is further a view for explaining a characteristic of the present invention. This embodiment also has the characteristics of the present invention as explained previously, and the long side Lz is set in a direction having a crystal axis in which the coefficient of linear expansion is closer to the coefficient of linear expansion of the package 2. Furthermore, in the embodiment of Fig. 9, a distance from a central position of the piezoelectric element 1 to electrode pads P₅₀ to P₅₄ is a length not exceeding half a length of the short side Lx.

Thus, it is possible to further reduce the stress load applied to the bumps connected to the electrode pads P₅₀ to P₅₄.

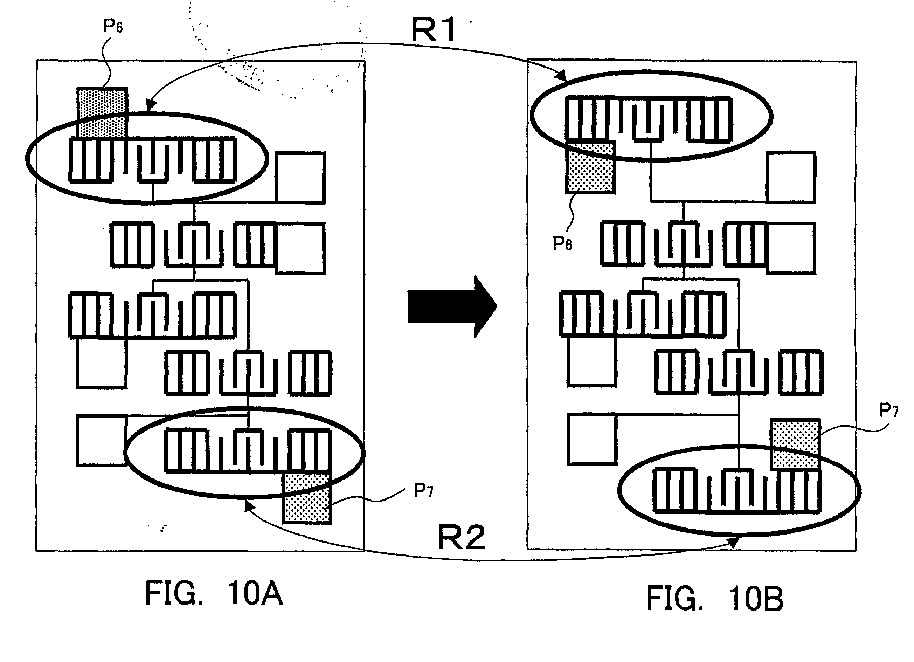

Fig. 10 is further a view showing an embodiment for explaining another characteristic of the present invention. This embodiment is based on the idea that the positions of the electrode pads of Fig. 9 are disposed at a distance close to a central position of the piezoelectric element 1.

That is, in the ladder type filter shown in Fig. 10A, a ground electrode pad P₆ of a parallel resonator R1 and a ground electrode pad P₇ of a serial resonator R2 are outside the parallel resonators R1, R2, respectively. Accordingly, as the extension of the characteristic of the present invention in Fig. 9, the ground electrode pads P₆ and P₇ are disposed inside the parallel resonators R1, R2, respectively, as shown in Fig. 10B.

Thus, it is possible to reduce the distance from the center of the piezoelectric element 1 of the ground electrode pads P₆ and P₇, and accordingly, it is possible to reduce the stress load applied to the bump connected to the ground electrode pads P₆ and P₇.

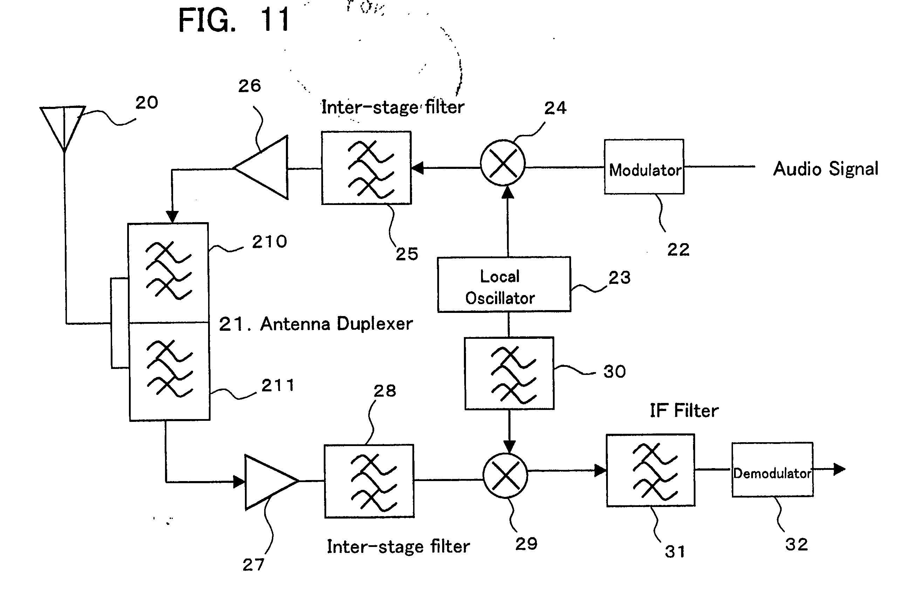

Here, the adaptation of the filter in a communication device will be considered. Fig. 11 is a block diagram centering on a radio communication device, for example, a high frequency circuit of a portable telephone. An antenna duplexer 21 linked with an antenna 20 has a transmitting filter 210 and a receiving filter 211. The transmitting filter 210 and receiving filter 211 have a predetermined passband, respectively, and their central frequencies are different.

The transmission side modulates the transmission of an IF signal with an audio or digital signal by means of a modulator 22 . The modulated signal is mixed with a carrier signal from a local oscillator 23 by a mixer 24, and is transformed into a transmitting frequency band signal. This signal then passes through an inter-stage filter 25, is power-amplified by a power amplifier 26, passes through the transmitting filter 210 of the antenna duplexer 21, and is sent from the antenna 20.

On the other hand, reception signals are received by the antenna 20 pass the receiving filter 211 of the antenna duplexer 21, and are amplified by a pre-amplifier 27. The output of the pre-amplifier 27 is passed through an inter-stage filter 28 and is led to a mixer 29.

A frequency signal differing from a transmitting frequency is extracted by a filter 30 out of frequency signals output from the local oscillator 23, and thus the received signals are converted into IF signals by the mixer 29. From the converted IF signals higher harmonic components are removed by an IF filter 31, and are fed to a demodulator 32 for demodulation.

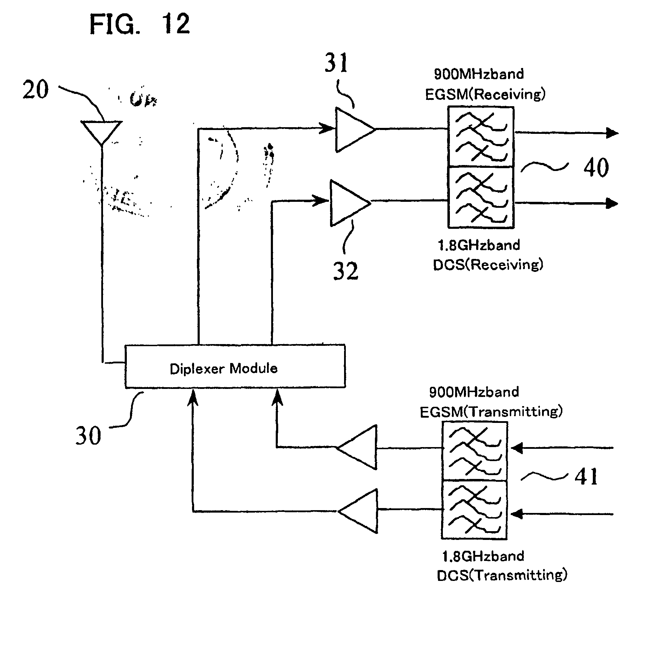

Fig. 12 is further a block diagram centering on another high frequency circuit of a portable telephone. In particular, it is a schematic configuration of a high frequency circuit part of a portable telephone for use in Europe. That is, one telephone is configured so as to correspond to two systems. This corresponds to an EGSM system having a frequency band of 900MHz and a DCS system having a frequency band of 1.8GHz.

For this reason, transmitting and receiving dual filters 40, 41 are provided for each system. Furthermore, in some cases, a SAW filter may be further mounted between a system linked with the antenna 20, and for example, a duplexer module 30 for separating transmitting and receiving signals, and amplifiers 31, 32.

Each later stage of inter-stage filters 40, 41 is connected to a modulation and demodulation circuit in the same manner as the configuration in Fig. 11, and as this has no connection with the explanation of the present invention, further explanation is omitted.

As understood readily from the description of Figs. 11 and 12, in the case where the plurality of filters are used for the communication device, and downsizing is demanded as in the portable telephone, a smaller-sized surface acoustic wave device is necessary for realizing these filters.

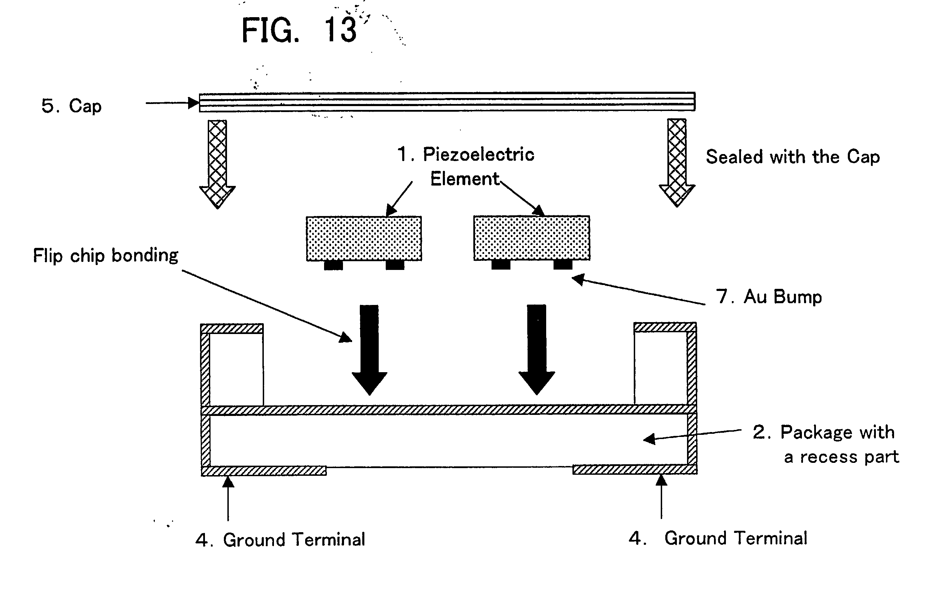

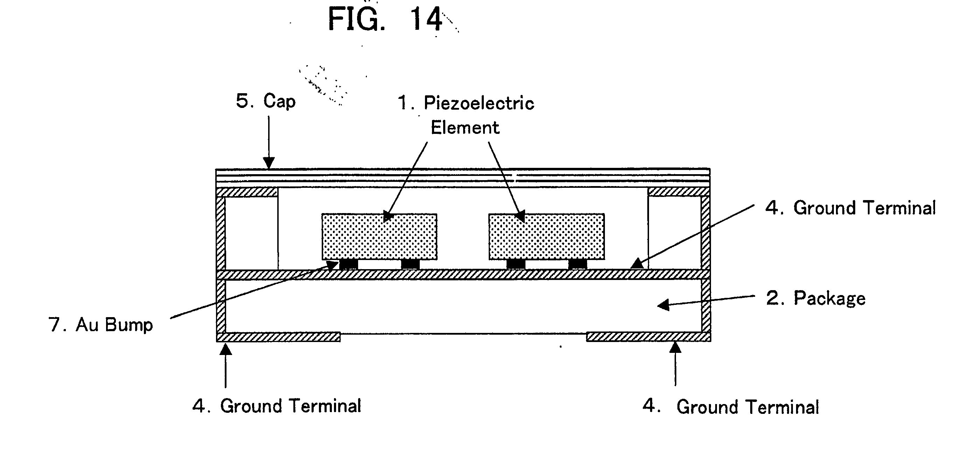

Fig. 13 is a view for explaining the mounting of the surface acoustic wave device according to an embodiment of the present invention in response to such demands. Fig. 14 is a view showing the condition of the bumps 7 after mounting. The embodiment is an example in which the two piezoelectric elements 1 having the previously explained characteristics of the present invention are mounted commonly in the package 2, and are sealed with the cap 5. The package 2 has a recess part, and the ground terminal and I/O terminals are connected to the electrode pad corresponding to the piezoelectric element 1 via the Au bumps 7 to be fixed to each other.

Here, as explained previously, the long side of the piezoelectric element 1 is selected in an axial direction close to the coefficient of linear expansion of the package 2, and the electrode pads are disposed symmetrically to a center of the piezoelectric element 1. Accordingly, in Fig. 14, the stress on the bumps 7 is decreased.

The example of Fig. 14 is one in which the ground electrode pads of the two piezoelectric elements 1 are commonly connected to the ground terminal 4 of the package 2.

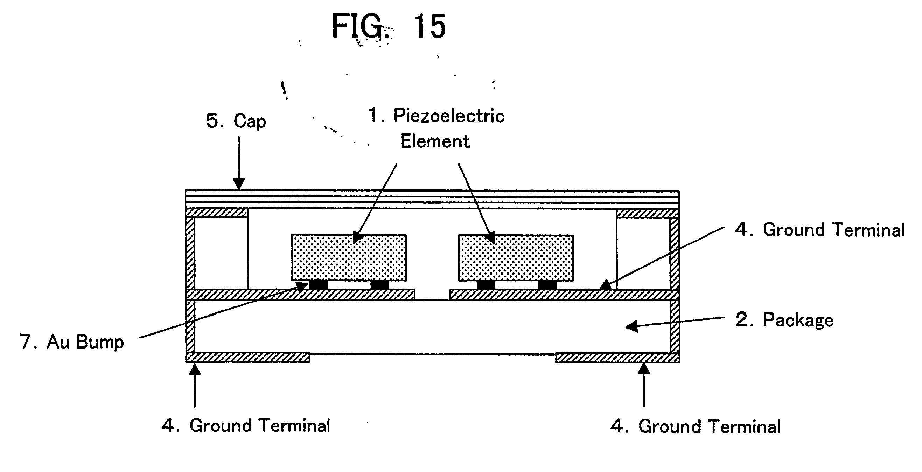

Fig. 15 is another example, in which the two piezoelectric elements 1 are mounted via ground electrode pads onto separate ground terminals 4 of the common package 2. Thus, it is possible to prevent interference between the two piezoelectric elements 1.

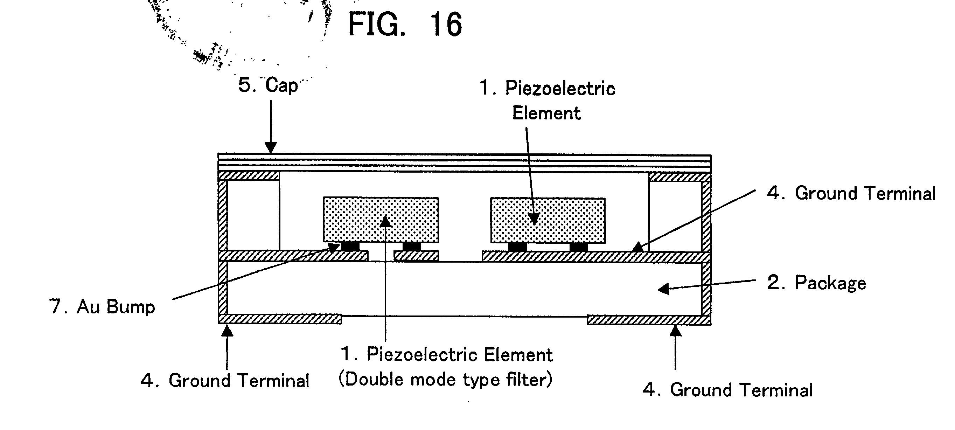

Fig. 16 is another example, in which input and output ground electrode pads of the two surface acoustic wave elements formed an one of the piezoelectric elements 1 are separated from each other so that only one of the electrode pads connects with one ground terminal 4 of the package 2. Thus, it is possible to prevent interference between the input and output.

Such an example may be applied to the cascade-connected two-stage double mode type filter in the connection electrodes 103, 104 explained previously in Fig. 7, a single-stage double mode type filter, or the like.

Here, in Figs. 13 to 16, the explanation was made with reference to examples in which two piezoelectric elements are mounted in a common package, but the application of the present invention is not limited to such an example. The case where two piezoelectric elements are mounted in a common package, is applied, for example, to the antenna duplexer 21 in Fig. 11, or the dual filters 40, 41 in Fig. 12.

Furthermore, in the case where the two or more piezoelectric elements are mounted on the common package, for example, in Fig. 11, this configuration can apply to the inter-stage filter, IF filter, or a filter for another system. -

Incidentally, in the description of the above embodiments, the description refers to a case where a single filter is configured on a single piezoelectric element, but the present invention is not limited thereto, and the two or more filters may be configured on a single piezoelectric element.

Hereinabove, the embodiments were described with reference to the drawings, and according to the present invention, it is possible to downsize with high reliability a surface acoustic wave device in which a piezoelectric element forms a surface acoustic element and is mounted on a package using flip chip bonding technology.

## Claims

1. A surface acoustic wave device, comprising:
a package (2) having a coefficient of linear expansion; and
a piezoelectric element (1) forming a surface acoustic wave element, and mounted on the package by flip chip bonding;
**characterised in that**: the piezoelectric element has different coefficients of linear expansion in first and second directions, the first direction being a direction of propagation of surface acoustic waves generated by interdigital electrodes of the surface acoustic wave element and the second direction being perpendicular thereto, and further having a long side (Lz) extending in whichever of the first and second directions has a coefficient of linear expansion closer to that of the package (2).

2. The surface acoustic wave device according to claim 1,
wherein
the piezoelectric element (1) has electrode patterns, and positions of bumps (7) which connect the electrode patterns with the package (2) are disposed point-symmetrically to a center of the piezoelectric element (1).

3. The surface acoustic wave device according to claim 2,
wherein
the electrode patterns are formed so that a distance from the center of the piezoelectric element (1) is 1/2 or less of a short side (Lx) of the piezoelectric element.

4. The surface acoustic wave device according to claims 1, 2, or 3, wherein
the surface acoustic wave element (1) has electrode patterns configuring a ladder-type filter (101, 102).

5. The surface acoustic wave device according to claim 4,
wherein
all positions of the bumps (7) which connect the electrode patterns with the package (2) are disposed at a side closer to the center of the piezoelectric element (1) than a resonator disposed at a side of the short side (Lx) of the ladder-type filter (101, 102).

6. A surface acoustic wave device, comprising:
a package (2) having a coefficient of linear expansion; and
a surface acoustic wave element mounted on the package by flip chip bonding;
**characterised in that**: the surface acoustic wave element is formed by two piezoelectric elements (1), each of the two piezoelectric elements having different coefficients of linear expansion in first and second directions, the first direction being a direction of propagation of surface acoustic waves generated by interdigital electrodes of the surface acoustic wave element and the second direction being perpendicular thereto, and having a long side (Lz) extending in whichever of the first and second directions has a coefficient of linear expansion closer to that of the package, and **in that** each of the piezoelectric elements has respective different central frequencies.

7. The surface acoustic wave device according to claim 6,
wherein
a ground electrode of the surface acoustic wave element formed respectively on the two piezoelectric elements is common in the package (2).

8. The surface acoustic wave device according to claim 6,
wherein
ground electrodes of the surface acoustic wave elements formed respectively on the two piezoelectric elements are independent in the package (2).

9. The surface acoustic wave device according to any of claims 1, 2, 3 or 4, wherein
the surface acoustic wave element is a double mode type filter, in which an input side ground electrode and output side ground electrode of the filter are separated in the package (2).

10. The surface acoustic wave device according to claim 6,
wherein
the surface acoustic wave element formed in any one of the two piezoelectric elements is a cascade-connected double mode type filter (101, 102), in which an input side ground electrode and output side ground electrode of the filter are separated in the package (2).

11. The surface acoustic wave device according to any preceding claim, wherein
the piezoelectric element (1) is cut out from a single crystal having X, Y, and Z crystal axes, and the X crystal axis agrees with a direction of propagation of the surface acoustic waves.

12. The surface acoustic wave device according to claim 11,
wherein
the piezoelectric element (1) is cut at a Y-axis rotation of angle 40 to 44 degrees from a LiTaO₃ single crystal-rotated around the X axis at a rotated angle from the Y axis to the Z axis, the rotated angle being in a range between 40° to 44°.

13. A communication device, comprising:
a package (2) having a coefficient of linear expansion; and
a piezoelectric element (1) forming a surface acoustic wave element, and mounted on the package by flip chip bonding;
wherein the piezoelectric element has different coefficients of linear expansion in first and second directions, the first direction being a direction of propagation of surface acoustic waves generated by interdigital electrodes of the surface acoustic wave element and the second direction being perpendicular thereto, and further having a long side (Lz) extending in whichever of the first and second directions has a coefficient of linear expansion closer to that of the package (2).

14. An antenna duplexer (21), comprising:
a package (2) having a coefficient of linear expansion; and
surface acoustic wave element means mounted on the package (2) by flip chip bonding;
wherein said surface acoustic wave element means are provided by two piezoelectric elements (1) respectively forming a surface acoustic wave element; each of the two piezoelectric elements having different coefficients of linear expansion in first and second directions, the first direction being a direction of propagation of surface acoustic waves generated by interdigital electrodes of the surface acoustic wave element and the second direction being perpendicular thereto, and having a long side (Lz) extending in whichever of the first and second directions has a coefficient of linear expansion closer to that of the package (2); and in that
respective central frequencies of surface acoustic wave filters (210, 211) formed by the two piezoelectric elements are different.

## Patentansprüche

1. Eine akustische Oberflächenwellenvorrichtung, umfassend:
ein Gehäuse (2), welches einen Koeffizienten linearer Expansion besitzt, und
ein piezoelektrisches Element (1), welches ein akustisches Oberflächenwellenelement bildet und welches auf dem Gehäuse durch Flip-Chip-Bonden montiert ist;
**dadurch gekennzeichnet, dass**: das piezoelektrische Element unterschiedliche Koeffizienten linearer Expansion in einer ersten und einer zweiten Richtung besitzt, wobei die erste Richtung eine Ausbreitungsrichtung akustischer Oberflächenwellen ist, welche durch Interdigitalelektroden des akustischen Oberflächenwellenelements erzeugt werden, und wobei die zweite Richtung senkrecht dazu ist, und des Weiteren eine Längsseite (Lz) besitzt, welche sich in jene der ersten und der zweiten Richtung erstreckt, die einen Koeffizienten linearer Expansion besitzt, der dem des Gehäuses (2) näher ist.

2. Die akustische Oberflächenwellenvorrichtung nach Anspruch 1, worin
das piezoelektrische Element (1) Elektrodenmuster besitzt und Positionen von Bumps (7), welche die Elektrodenmuster mit dem Gehäuse (2) verbinden, punktsymmetrisch zu einer Mitte des piezoelektrischen Elements (1) angeordnet sind.

3. Die akustische Oberflächenwellenvorrichtung nach Anspruch 2, worin
die Elektrodenmuster so geformt sind, dass eine Distanz von der Mitte des piezoelektrischen Elements (1) 1/2 oder weniger einer kurzen Seite (Lx) des piezoelektrischen Elements ist.

4. Die akustische Oberflächenwellenvorrichtung nach Anspruch 1, 2 oder 3, worin
das akustische Oberflächenwellenelement (1) Elektrodenmuster besitzt, welche ein Filter (101, 102) vom Abzweigtyp konfigurieren.

5. Die akustische Oberflächenwellenvorrichtung nach Anspruch 4, worin
alle Positionen der Bumps (7), welche die Elektrodenmuster mit dem Gehäuse (2) verbinden, auf einer Seite angeordnet sind, welche näher zu der Mitte des piezoelektrischen Elements (1) ist als ein Resonator, der auf einer Seite der kurzen Seite (Lx) des Filters (101, 102) vom Abzweigtyp angeordnet ist.

6. Eine akustische Oberflächenwellenvorrichtung, umfassend:
ein Gehäuse (2), welches einen Koeffizienten linearer Expansion besitzt; und
ein akustisches Oberflächenwellenelement, welches auf dem Gehäuse durch Flip-Chip-Bonden montiert ist;
**dadurch gekennzeichnet, dass**: das akustische Oberflächenwellenelement durch zwei piezoelektrische Elemente (1) geformt ist, wobei jedes der zwei piezoelektrischen Elemente unterschiedliche Koeffizienten linearer Expansion in einer ersten und einer zweiten Richtung besitzt, wobei die erste Richtung eine Ausbreitungsrichtung akustischer Oberflächenwellen ist, welche durch Interdigitalelektroden des akustischen Oberflächenwellenelements erzeugt werden, und wobei die zweite Richtung senkrecht dazu ist, und eine Längsseite (Lz) besitzt, welche sich in jene der ersten und der zweiten Richtung erstreckt, die einen Koeffizienten linearer Expansion besitzt, der dem des Gehäuses näher ist, und dass jedes der piezoelektrischen Elemente jeweils unterschiedliche Mittenfrequenzen besitzt.

7. Die akustische Oberflächenwellenvorrichtung nach Anspruch 6, worin
eine Masseelektrode des akustischen Oberflächenwellenelements, welches jeweils auf den zwei piezoelektrischen Elementen geformt ist, eins in dem Gehäuse (2) ist.

8. Die akustische Oberflächenwellenvorrichtung nach Anspruch 6, worin
Masseelektroden der akustischen oberflächenwellenelemente, welche jeweils auf den zwei piezoelektrischen Elementen geformt sind, unabhängig in dem Gehäuse (2) sind.

9. Die akustische Oberflächenwellenvorrichtung nach einem der Ansprüche 1, 2, 3 oder 4, worin
das akustische Oberflächenwellenelement ein Filter vom Doppelmodustyp ist, wobei eine Masseelektrode für eine Eingangsseite und eine Masseelektrode für eine Ausgangsseite des Filters in dem Gehäuse (2) getrennt sind.

10. Die akustische Oberflächenwellenvorrichtung nach Anspruch 6, worin
das akustische Oberflächenwellenelement, welches in irgendeinem der zwei piezoelektrischen Elemente geformt ist, ein Kaskadenschaltungsfilter (101, 102) vom Doppelmodustyp ist, wobei eine Masseelektrode für eine Eingangsseite und eine Masseelektrode für eine Ausgangsseite des Filters in dem Gehäuse (2) getrennt sind.

11. Die akustische Oberflächenwellenvorrichtung nach einem der vorhergehenden Ansprüche, worin
das piezoelektrische Element (1) aus einem einzelnen Kristall ausgeschnitten ist, das X-, Y- und Z- Kristallachsen besitzt, und die X-Kristallachse mit einer Ausbreitungsrichtung der akustischen Oberflächenwellen übereinstimmt.

12. Die akustische Oberflächenwellenvorrichtung nach Anspruch 11, worin
das piezoelektrische Element (1) bei einer Y-Achsendrehung eines Winkels von 40 bis 44 Grad aus einem LiTaO₃ Einzelkristall geschnitten wird, der bei einem gedrehten Winkel von der Y-Achse zu der Z-Achse um die X-Achse gedreht wird, wobei der gedrehte Winkel in einem Bereich zwischen 40° und 44° liegt.

13. Eine Kommunikationsvorrichtung, umfassend:
ein Gehäuse (2), welches einen Koeffizienten linearer Expansion besitzt, und
ein piezoelektrisches Element (1), welches ein akustisches Oberflächenwellenelement bildet und welches auf dem Gehäuse durch Flip-Chip-Bonden montiert ist;
worin das piezoelektrische Element unterschiedliche Koeffizienten linearer Expansion in einer ersten und einer zweiten Richtung besitzt, wobei die erste Richtung eine Ausbreitungsrichtung akustischer Oberflächenwellen ist, welche durch Interdigitalelektroden des akustischen Oberflächenwellenelements erzeugt werden, und wobei die zweite Richtung senkrecht dazu ist, und des Weiteren eine Längsseite (Lz) besitzt, welche sich in jene der ersten und der zweiten Richtung erstreckt, die einen Koeffizienten linearer Expansion besitzt, der dem des Gehäuses (2) näher ist.

14. Eine Antennenweiche (21), umfassend:
ein Gehäuse (2), welches einen Koeffizienten linearer Expansion besitzt; und
akustische oberflächenwellenelementmittel, welche auf dem Gehäuse (2) durch Flip-Chip-Bonden montiert sind;
worin die akustischen Oberflächenwellenelementmittel durch zwei piezoelektrische Elemente (1) vorgesehen sind, welche jeweils ein akustisches Oberflächenwellenelement formen; wobei jedes der zwei piezoelektrischen Elemente unterschiedliche Koeffizienten linearer Expansion in einer ersten und einer zweiten Richtung besitzt, wobei die erste Richtung eine Ausbreitungsrichtung akustischer Oberflächenwellen ist, welche durch Interdigitalelektroden des akustischen oberflächenwellenelements erzeugt werden, und wobei die zweite Richtung senkrecht dazu ist, und eine Längsseite (Lz) besitzt, welche sich in jene der ersten und der zweiten Richtung erstreckt, die einen Koeffizienten linearer Expansion besitzt, der dem des Gehäuses (2) näher ist; und dass
jeweilige Mittenfrequenzen akustischer Oberflächenwellenfilter (210, 211), welche durch die zwei piezoelektrischen Elemente geformt werden, unterschiedlich sind.

## Revendications

1. Dispositif à ondes acoustiques de surface, comportant :
un boîtier (2) ayant un coefficient de dilatation linéaire ; et
un élément piézoélectrique (1) formant un élément à ondes acoustiques de surface, et monté sur le boîtier par liaison du type « flip chip » ;
**caractérisé en ce que** : l'élément piézoélectrique a des coefficients de dilatation linéaire différents dans des première et deuxième directions, la première direction étant une direction de propagation d'ondes acoustiques de surface générées par des électrodes interdigitales de l'élément à ondes acoustiques de surface et la deuxième direction étant perpendiculaire à celle-ci, et ayant en outre un côté long (Lz) s'étendant dans celle des première et deuxième directions qui a un coefficient de dilatation linéaire plus proche de celui du boîtier (2).

2. Dispositif à ondes acoustiques de surface selon la revendication 1, dans lequel
l'élément piézoélectrique (1) a des dessins d'électrode, et des positions des plots (7) qui relient les dessins d'électrode au boîtier (2) sont disposées de manière symétrique par rapport à un centre de l'élément piézoélectrique (1).

3. Dispositif à ondes acoustiques de surface selon la revendication 2, dans lequel
les dessins d'électrode sont formés de telle sorte qu'une distance par rapport au centre de l'élément piézoélectrique (1) est 1/2 ou moins d'un côté court (Lx) de l'élément piézoélectrique.

4. Dispositif à ondes acoustiques de surface selon les revendications 1, 2, ou 3, dans lequel
l'élément à ondes acoustiques de surface (1) a des dessins d'électrode qui configurent un filtre du type en échelle (101, 102).

5. Dispositif à ondes acoustiques de surface selon la revendication 4, dans lequel
toutes les positions des plots (7) qui relient les dessins d'électrode au boîtier (2) sont disposées au niveau d'un côté plus proche du centre de l'élément piézoélectrique (1) qu'un résonateur disposé au niveau d'un côté du côté court (Lx) du filtre du type en échelle (101, 102).

6. Dispositif à ondes acoustiques de surface, comportant :
un boîtier (2) ayant un coefficient de dilatation linéaire ; et
un élément à ondes acoustiques de surface monté sur le boîtier par liaison du type « flip chip » ;
**caractérisé en ce que** : l'élément à ondes acoustiques de surface est formé par deux éléments piézoélectriques (1), chacun des deux éléments piézoélectriques ayant des coefficients de dilatation linéaire différents dans des première et deuxième directions, la première direction étant une direction de propagation des ondes acoustiques de surface générées par des électrodes interdigitales de l'élément à ondes acoustiques de surface et la deuxième direction étant perpendiculaire à celle-ci, et ayant un côté long (Lz) s'étendant dans celle des première et deuxième directions qui a un coefficient de dilatation linéaire plus proche de celui du boîtier, et **en ce que** chacun des éléments piézoélectriques a des fréquences centrales respectives différentes.

7. Dispositif à ondes acoustiques de surface selon la revendication 6, dans lequel
une électrode de masse de l'élément à ondes acoustiques de surface formée de manière respective sur les deux éléments piézoélectriques est commune dans le boîtier (2).

8. Dispositif à ondes acoustiques de surface selon la revendication 6, dans lequel
les électrodes de masse des éléments à ondes acoustiques de surface formées de manière respective sur les deux éléments piézoélectriques sont indépendantes dans le boîtier (2).

9. Dispositif à ondes acoustiques de surface selon l'une quelconque des revendications 1, 2, 3 ou 4, dans lequel
l'élément à ondes acoustiques de surface est un filtre du type à double mode, dans lequel une électrode de masse du côté entrée et une électrode de masse du côté sortie du filtre sont séparées dans le boîtier (2).

10. Dispositif à ondes acoustiques de surface selon la revendication 6, dans lequel
l'élément à ondes acoustiques de surface formé dans l'un quelconque des deux éléments piézoélectriques est un filtre du type à double mode relié en cascade (101, 102), dans lequel une électrode de masse du côté entrée et une électrode de masse du côté sortie du filtre sont séparées dans le boîtier (2).

11. Dispositif à ondes acoustiques de surface selon l'une quelconque des revendications précédentes, dans lequel
l'élément piézoélectrique (1) est taillé dans un monocristal ayant des axes de cristal X, Y et Z, et l'axe de cristal X correspond à une direction de propagation des ondes acoustiques de surface.

12. Dispositif à ondes acoustiques de surface selon la revendication 11, dans lequel
l'élément piézoélectrique (1) est taillé avec une rotation d'axe Y d'angle de 40 à 44 degrés dans un monocristal de LiTaO₃ tourné autour de l'axe X avec un angle tourné de l'axe Y vers l'axe Z, l'angle de rotation étant dans une plage entre 40° et 44°.

13. Appareil de communication, comportant :
un boîtier (2) ayant un coefficient de dilatation linéaire ; et
un élément piézoélectrique (1) formant un élément à ondes acoustiques de surface, et monté sur le boîtier par liaison du type « flip chip » ;
l'élément piézoélectrique ayant des coefficients de dilatation linéaire différents dans des première et deuxième directions, la première direction étant une direction de propagation d'ondes acoustiques de surface générées par des électrodes interdigitales de l'élément à ondes acoustiques de surface et la deuxième direction étant perpendiculaire à celle-ci, et ayant en outre un côté long (Lz) s'étendant dans celle des première et deuxième directions qui a un coefficient de dilatation linéaire plus proche de celui du boîtier (2).

14. Duplexeur d'antenne (21), comportant :
un boîtier (2) ayant un coefficient de dilatation linéaire ; et
des moyens d'élément à ondes acoustiques de surface montés sur le boîtier (2) par liaison du type « flip chip » ;
lesdits moyens d'élément à ondes acoustiques de surface étant procurés par deux éléments piézoélectriques (1) formant respectivement un élément à ondes acoustiques de surface ; chacun des deux éléments piézoélectriques ayant des coefficients de dilatation linéaire différents dans des première et deuxième directions, la première direction étant une direction de propagation des ondes acoustiques de surface générées par des électrodes interdigitales de l'élément à ondes acoustiques de surface et la deuxième direction étant perpendiculaire à celle-ci, et ayant un côté long (Lz) s'étendant dans celle des première et deuxième directions qui a un coefficient de dilatation linéaire plus proche de celle du boîtier (2) ; et
des fréquences centrales respectives des filtres à ondes acoustiques de surface (210, 211) formés par les deux éléments piézoélectriques étant différentes.
